# EUROPÄISCHE PATENTSCHRIFT

(11) **EP 2 057 695 B1**
(45) Veröffentlichungstag und Bekanntmachung des Hinweises auf die Patenterteilung: **15.08.2018**
(21) Anmeldenummer: 07817592.4
(22) Anmeldetag: 27.09.2007
(51) Int. Cl.: H01L 33/00, H01L 31/0203, H01L 31/0232

(54) **GEHÄUSE FÜR EIN OPTOELEKTRONISCHES BAUELEMENT, OPTOELEKTRONISCHES BAUELEMENT UND VERFAHREN ZUM HERSTELLEN EINES GEHÄUSES FÜR EIN OPTOELEKTRONISCHES BAUELEMENT**
HOUSING FOR AN OPTOELECTRONIC COMPONENT, OPTOELECTRONIC COMPONENT AND METHOD FOR PRODUCING A HOUSING FOR AN OPTOELECTRONIC COMPONENT
BOÎTIER POUR COMPOSANT OPTOÉLECTRONIQUE, COMPOSANT OPTOÉLECTRONIQUE ET PROCÉDÉ DE FABRICATION D'UN BOÎTIER POUR COMPOSANT OPTOÉLECTRONIQUE

(30) Priorität: 29.09.2006 DE 102006046678
(43) Veröffentlichungstag der Anmeldung: 13.05.2009
(73) Patentinhaber: OSRAM Opto Semiconductors GmbH, 93055 Regensburg (DE)
(72) Erfinder: BOGNER, Georg, 93138 Lappersdorf (DE)
(74) Vertreter: Epping - Hermann - Fischer
(86) Internationale Anmeldenummer: PCT/DE2007/001750
(87) Internationale Veröffentlichungsnummer: WO 2008/040324

(56) Entgegenhaltungen:
- EP-A- 0 493 051
- WO-A-2006/032251
- DE-A1- 19 945 919
- US-A1- 2003 141 510
- US-A1- 2005 245 018
- US-A1- 2006 060 867

## Beschreibung

Die Erfindung betrifft ein Gehäuse für ein optoelektronisches Bauelement, insbesondere ein oberflächenmontierbares optoelektronisches Bauelement, mit einem Kunststoff-Grundkörper, der eine Vorderseite mit einem Montagebereich für mindestens einen strahlungsemittierenden oder strahlungsdetektierenden Körper aufweist. Sie betrifft weiterhin ein insbesondere oberflächenmontierbares optoelektronisches Bauelement und ein Verfahren zum Herstellen eines Gehäuses für ein optoelektronisches Bauelement.
Gehäuse der eingangs genannten Art sind beispielsweise in den Druckschriften EP 1022787 B1, EP 00646971 B1, WO 99/07023 A1, WO 00/02262 A1 und WO 02/084749 A2 beschrieben. Hierbei handelt es sich um so genannte vorgehäuste Leadframe-Bauformen, bei denen ein einstückig ausgebildeter Kunststoff-Grundkörper, mit dem elektrische Anschlüsse des Leadframes (auch elektrischer Leiterrahmen genannt) umformt sind, herkömmlich in der Praxis aus einem weißen, reflektierenden Thermoplast-Material gefertigt ist.
Diese bekannten Kunststoff-Grundkörper weisen aber für eine Reihe von Anwendungen nicht hinreichend zufriedenstellende optische Eigenschaften auf. So ist beispielsweise für die Anwendung bei Video-Displays der Kontrast der Leuchtpunkte zur umgebenden Gehäuseoberfläche oftmals zu gering.
Ein Ansatz, diesem Problem zu begegnen, besteht darin, die Oberfläche des Kuntststoff-Grundkörpers nachträglich beispielsweise mit schwarzer Farbe zu bedrucken (siehe zum Beispiel US 2006/060867) Hierbei besteht jedoch die Gefahr von Farbinhomogenitäten in der Farbschicht, sowie auch von mangelnder Farbstabilität und/oder Farbabblätterungen unter Einfluss von verschiedenen Umweltbedingungen. Eine Aufgabe der vorliegenden Erfindung besteht darin, ein Gehäuse der eingangs genannten Art bereitzustellen, mit dem auf verbesserte Art und Weise gewünschte optische Eigenschaften der Gehäuseoberfläche erzielt werden können. Weiterhin soll ein Verfahren zum Herstellen eines solchen Gehäuses angegeben werden.
Diese Aufgaben werden durch ein Gehäuse mit den Merkmalen des Anspruches 1 bzw. durch ein Verfahren mit den Merkmalen des Patentanspruches 8 gelöst.

Vorteilhafte Ausgestaltungen und Weiterbildungen des Gehäuses, des Bauelements und des Verfahrens sind in den Unteransprüchen angegeben.
Der Offenbarungsgehalt der Ansprüche wird hiermit ausdrücklich durch Rückbezug in die Beschreibung aufgenommen.
Bei einem Gehäuse gemäß der Erfindung ist der Kunststoff-Grundkörper aus mindestens einer ersten Kunststoffkomponente und mindestens einer zweiten Kunststoffkomponente ausgebildet. Die zweite Kunststoffkomponente befindet sich dabei an der Vorderseite des Kunststoff-Grundkörpers und ist aus einem Material ausgebildet ist, das sich in mindestens einer optischen Eigenschaft von dem Material der ersten Kunststoffkomponente unterscheidet. Die Oberfläche der zweiten Kunststoffkomponente bildet, beispielsweise hervorgerufen durch Zugabe von Farbstoff oder reflexionssteigerndem Füllstoff, einen optischen Funktionsbereich des Kunststoff-Grundkörpers aus. So kann vorteilhafterweise durch Zugabe von schwarzem Farbstoff eine Kontrasterhöhung erzielt werden. Durch Zugabe von weißem Füllstoff kann vorteilhafterweise die Reflektivität der vorderseitigen Oberfläche des Kunststoff-Grundkörpers erhöht werden.

Bei einer vorteilhaften Ausgestaltung umschließt der Kunststoff-Grundkörper elektrische Anschlussleiter eines metallischen Leadframes, derart, dass diese vom Montagebereich zur Oberfläche des Kunststoff-Grundkörpers verlaufen. Der Montagebereich ist dabei in einer reflektorartigen Vertiefung des Kunststoff-Grundkörpers angeordnet. Die zweite Kunststoffkomponente bildet entlang der gesamten Vorderseite oder entlang eines Teilbereiches der Vorderseite des Kunststoff-Grundkörpers bis auf die reflektorartige Vertiefung eine Schicht aus. Bei einer anderen vorteilhaften Ausgestaltung ist diese Schicht zusätzlich auch entlang zumindest eines Teilbereiches der seitlichen Innenflächen in die reflektorartige Vertiefung gezogen.

Die Dicke der Schicht liegt vorteilhafterweise zwischen einschließlich 50 µm und einschließlich 100 µm.

Bei einer weiteren vorteilhaften Ausgestaltung ist die zweite Kunststoffkomponente aus dem gleichen Kunststoff-Grundmaterial gefertigt wie die erste Kunststoffkomponente. Als Kunststoff-Grundmaterial eignet sich vorzugsweise Thermoplast-Material oder Duroplast-Material.

Bei einem Verfahren gemäß der Erfindung wird mittels eines Zweikomponenten-Spritzverfahrens (auch Doppelspritzverfahren genannt) ein Kunststoff-Grundkörper hergestellt. Bevorzugt wird in einem ersten Schritt dabei ein tragender Teil des Kunststoff-Grundkörpers aus einer ersten Kunststoffkomponente hergestellt und in einem weiteren Schritt ein optischer Funktionsbereich des Kunststoff-Grundkörpers aus einer zweiten Kunststoffkomponente hergestellt. Die beiden Kunststoffkomponenten unterscheiden sich in mindestens einer optischen Eigenschaft voneinander. Bei einem alternativen Verfahren werden diese beiden Schritte in umgekehrter Reihenfolge ausgeführt.

Vorliegend und im Rahmen der Beschreibung der Ausführungsbeispiele fallen unter den Begriff "Spritzverfahren" sowohl Spritzgussverfahren und Spritzpressverfahren, wie auch Transfermoldverfahren.

Bei einem Verfahren zum Herstellen eines Gehäuses mit verbessertem Kontrast wird in die zweite Kunststoffkomponente beispielsweise ein Farbstoff eingemischt, der diesem eine gegenüber der ersten Kunststoffkomponente verschiedene Farbe verleiht. Hierzu eignet sich vorzugsweise eine schwarze Einfärbung. Um beispielsweise die Reflektivität der Gehäuse-Vorderseite zu verbessern wird bei einer anderen Ausführungsform die zweite Kunststoffkomponente mit einem reflexionssteigerenden Material gefüllt.

Bei einer besonders vorteilhaften Ausgestaltung des Verfahrens werden elektrische Anschlussleiter eines metallischen Leiterrahmens mit der ersten Kunststoffkomponente derart umspritzt, dass diese vom Montagebereich für mindestens einen strahlungsemittierenden oder strahlungsdetektierenden Körper zur Oberfläche des Kunststoff-Grundkörpers verlaufen. Nachfolgend wird in einem weiteren Schritt die zweite Kunststoffkomponente an der ersten Kunststoffkomponente ausgebildet. In der ersten Kunststoffkomponente des Kunststoff-Grundkörpers wird dabei vorzugsweise eine reflektorartige Vertiefung ausgebildet, in der sich der Montagebereich für den Halbleiterkörper befindet. Weiterhin vorzugsweise wird der optische Funktionsbereich aus dem gleichen Kunststoff-Grundmaterial gefertigt, wie der übrige Kunststoff-Grundkörper. Als Kunststoff-Grundmaterial eignet sich, wie oben bereits angegeben, vorzugsweise Thermoplast-Material oder Duroplast-Material.

Bei einem optoelektronischen Bauelement gemäß der Erfindung ist mindestens ein Halbleiterkörper, der geeignet ist, elektromagnetische Strahlung auszusenden und/oder zu detektieren (beispielsweise ein Leuchtdioden- oder Laserdidoenchip oder ein Photodiodenchip), in einem Kunststoff-Grundkörper befestigt. Der Kunststoff-Grundkörper weist an seiner Vorderseite einen Montagebereich für den Halbleiterkörper auf, der von einem lichtdurchlässigen Fensterteil umgeben ist und den Halbleiterkörper verkapselt. Elektrische Anschlussleiter verlaufen vom Montagebereich zur äußeren Oberfläche des Kunststoff-Grundkörpers. Der Halbleiterkörper ist bevorzugt auf einem der elektrischen Anschlussleiter angeordnet. Elektrische Anschlussflächen des Halbleiterkörpers sind elektrisch leitend mit den elektrischen Anschlussleitern verbunden, beispielsweise einerseits mittels einer elektrischen Anschlussschicht zwischen einer rückseitigen Anschlussfläche und dem einen elektrischen Anschlussleiter und andererseits mittels eines Bonddrahtes zwischen einer vorderseitigen Anschlussfläche und einem zweiten elektrischen Anschlussleiter. Der Halbleiterkörper kann aber auch anderweitig mittels geeigneten elektrischen Verbindungsmitteln mit den Anschlussleitern verbunden sein. An der Vorderseite des Kunststoff-Grundkörpers ist ein optischer Funktionsbereich aus einem Material ausgebildet, dessen optische Eigenschaften von denen des übrigen Materials des Kunststoff-Grundkörpers verschieden sind.

Der optische Funktionsbereich ist durch eine freie Oberfläche einer gesonderten Kunststoffkomponente des Kunststoff-Grundkörpers ausgebildet, beispielsweise hervorgerufen durch Zugabe von Farbstoff oder reflexionssteigernden Füllstoff zu der gesonderten Kunststoffkomponente. So kann vorteilhafterweise durch Zugabe von schwarzem Farbstoff eine Kontrasterhöhung erzielt werden. Durch Zugabe von weißem Füllstoff kann vorteilhafterweise die Reflektivität der Vorderseite des Kunststoff-Grundkörpers erhöht werden.

Der Montagebereich ist mit Vorteil in einer reflektorartigen Vertiefung des Kunststoff-Grundkörpers angeordnet. Bei einer weiteren vorteilhaften Ausgestaltung ist die gesonderte Kunststoffkomponente aus dem gleichen Kunststoff-Grundmaterial gefertigt wie die Kunststoffkomponente(n), die den übrigen Kunststoff-Grundkörper ausbildet(ausbilden). Als Kunststoff-Grundmaterial eignet sich vorzugsweise Thermoplast-Material oder Duroplast-Material.

Die gesonderte Kunststoffkomponente bildet entlang der gesamten Vorderseite oder entlang eines Teilbereiches der Vorderseite des Kunststoff-Grundkörpers bis auf die reflektorartige Vertiefung eine Schicht aus. Bei einer anderen vorteilhaften Ausgestaltung ist diese Schicht zusätzlich auch entlang zumindest eines Teilbereiches der seitlichen Innenflächen in die reflektorartige Vertiefung gezogen. Die Dicke der Schicht liegt bevorzugt zwischen einschließlich 50 µm und einschließlich 100 µm.

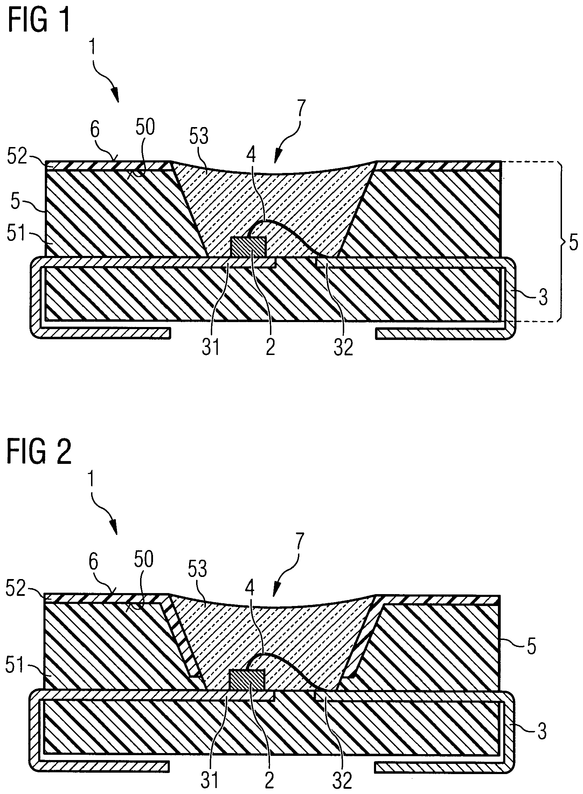

Weitere Vorteile, vorteilhafte Ausführungsformen und Weiterbildungen der Erfindung ergeben sich aus den im folgenden in Verbindung mit den Figuren 1 und 2 erläuterten Ausführungsbeispielen.

Es zeigen,
Figur 1, eine schematische Darstellung eines Schnittes durch ein erstes Ausführungsbeispiel und
Figur 2, eine schematische Darstellung eines Schnittes durch ein zweites Ausführungsbeispiel.

In den Figuren sind gleiche oder gleich wirkende Bestandteile jeweils mit den gleichen Bezugszeichen versehen. Die dargestellten Elemente und deren Größenverhältnisse untereinander sind grundsätzlich nicht als maßstabsgerecht anzusehen, vielmehr können einzelne Elemente, wie z. B. Schichten und/oder Abstände, zur besseren Darstellbarkeit und/oder zum besseren Verständnis übertrieben groß beziehungsweise dick dargestellt sein.

Bei dem Ausführungsbeispiel gemäß Figur 1 handelt es sich um ein Leuchtdiodenbauelement 1 mit einem Leuchtdiodenchip 2, der auf einem elektrischen Anschlussleiter 31 eines elektrischen Leiterrahmens 3 (Leadframe) befestigt und über einen Rückseitenkontakt mit diesem elektrisch leitend verbunden ist. Ein Vorderseitenkontakt des Leuchtdiodenchips 2 ist mittels eines Bonddrahtes 4 mit einem zweiten elektrischen Anschlussleiter 32 des elektrischen Leiterrahmens 3 verbunden.

Die elektrischen Anschlussleiter 31, 32 sind von einer ersten Kunststoffkomponente 51 eines Kunststoff-Grundkörpers 5 umformt. In einer reflektorartigen Vertiefung 7 an der Vorderseite 6 des Kunststoff-Grundkörpers 5 ist der Montagebereich für den Leuchtdiodenchip 2 ausgebildet. Die elektrischen Anschlussleiter 31, 32 verlaufen von der Bodenfläche der Vertiefung 7 durch die erste Kunststoffkomponente 51 hindurch zu deren seitlichen Oberflächen hin und ragen dort aus ihr heraus. Außerhalb des Kunststoff-Grundkörpers 5 sind die elektrischen Anschlussleiter 31, 32 zu dessen Rückseite hin und im weiteren Verlauf auf die Rückseite gebogen.

Eine vorderseitige Schicht des Kunststoff-Grundkörpers 5, deren Dicke beispielsweise zwischen 50 µm und 100 µm beträgt, ist von einer zweiten Kunststoffkomponente 52 gebildet, deren Material sich in mindestens einer optischen Eigenschaft von dem Material der ersten Kunststoffkomponente 51 unterscheidet. Die Oberfläche der zweiten Kunststoffkomponente 52 bildet einen optischen Funktionsbereich an der Vorderseite 6 des Kunststoff-Grundkörpers 5 aus. Dazu weist sie beispielsweise mindestens einen Farbstoff und/oder mindestens einen reflexionssteigernden Füllstoff auf. So wird mit schwarzem Farbstoff eine Kontrasterhöhung erzielt. Mit weißem Füllstoff, wie beispielsweise Titanoxid, wird beispielsweise die Reflektivität der vorderseitigen Oberfläche des Kunststoff-Grundkörpers 5 erhöht.

Die zweite Kunststoffkomponente 52 bedeckt die gesamte Vorderseite 50 der ersten Kunststoffkomponente 51 neben der reflektorartigen Vertiefung 7. Bei zweckmäßigen Ausgestaltungen (ohne Darstellung) kann nur ein Teil der Vorderseite 50 von der zweiten Kunststoffkomponente bedeckt sein.

Die zweite Kunststoffkomponente 52 ist aus dem gleichen Kunststoff-Grundmaterial gefertigt wie die erste Kunststoffkomponente 51, beispielsweise aus Thermoplast-Material oder Duroplast-Material. Das Kunststoff-Grundmaterial ist beispielsweise ein Material auf der Basis von Epoxidharz oder Acrylharz, kann aber auch jedes andere für Kunststoff-Grundkörper von sogenannten Premold-Bauformen geeignete Material sein.

In der reflektorartigen Vertiefung 7 befindet sich ein Fensterteil 53, das beispielsweise aus einem transparenten oder transluzenten Kunststoffmaterial, beispielsweise aus einem Reaktionsharz wie Epoxidharz oder Silikonharz, gefertigt ist. Dieses Fensterteil verkapselt den Leuchtdiodenchip 2 und dient unter anderem zum Schutz vor Beeinträchtigungen durch Umwelteinflüsse.

Der Kunststoff-Grundkörper 5, das Fensterteil 53 und der Leiterrahmen 3 bilden zusammen das Gehäuse des Leuchtdiodenbauelements 1.

Das Ausführungsbeispiel gemäß Figur 2 unterscheidet sich von dem gemäß Figur 1 insbesondere dadurch, dass die Schicht aus der zweiten Kunststoffkomponente 52 bis in die reflektorartige Vertiefung 7 hinein gezogen ist, so dass ein Teil der seitlichen Innenfläche der Vertiefung 7 von einer Oberfläche der zweiten Kunststoffkomponente 52 gebildet ist. Die Materialien des Ausführungsbeispiels gemäß Figur 2 entsprechen beispielsweise denen des oben beschriebenen Ausführungsbeispiels gemäß Figur 1.

Beide oben beschriebenen Ausführungsbeispiele für das Gehäuse sind auch bei Photodiodenbauelementen anwendbar. Dazu wird an Stelle des Leuchtdiodenchips ein Photodiodenchip verwendet.

Bei einem Verfahren zum Herstellen eines Gehäuses für ein Bauelement gemäß den oben beschriebenen Ausführungsbeispielen wird mittels eines Zweikomponenten-Spritzverfahrens (auch Doppelspritzverfahren genannt) ein Kunststoff-Grundkörper 5 hergestellt. In einem ersten Schritt wird dabei die erste Kunststoffkomponente 51 als tragender Teil des Kunststoff-Grundkörpers hergestellt. Danach wird in einem weiteren Schritt die zweite Kunststoffkomponente 51, die den optischen Funktionsbereich des Kunststoff-Grundkörpers 5 aufweist, hergestellt. Die beiden Kunststoffkomponenten 51, 52 unterscheiden sich, wie im Zusammenhang mit den obigen Ausführungsbeispielen näher erläutert, in mindestens einer optischen Eigenschaft voneinander.

Bei dem Verfahren werden im ersten Schritt die elektrischen Anschlussleiter 31, 32 des metallischen Leiterrahmens 3 mit der ersten Kunststoffkomponente 51 derart umspritzt, dass diese vom Montagebereich für den Leuchtdiodenchip zu den Seitenflächen des Kunststoff-Grundkörpers 5 verlaufen. Nachfolgend wird die zweite Kunststoffkomponente 52 an der Vorderseite der ersten Kunststoffkomponente 51 ausgebildet.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet.

## Patentansprüche

1. Gehäuse für ein optoelektronisches Bauelement (1) mit einem Kunststoff-Grundkörper (5), der eine Vorderseite (6) mit einem Montagebereich für mindestens einen strahlungsemittierenden oder strahlungsdetektierenden Körper (2) aufweist, und der Kunststoff-Grundkörper (5) aus mindestens einer ersten Kunststoffkomponente (51) und mindestens einer zweiten Kunststoffkomponente (52) ausgebildet ist, wobei die zweite Kunststoffkomponente (52)
- an der Vorderseite (6) des Kunststoff-Grundkörpers (5) angeordnet ist,
- aus einem Material ausgebildet ist, das sich in mindestens einer optischen Eigenschaft von dem Material der ersten Kunststoffkomponente (51) unterscheidet, und
- einen optischen Funktionsbereich des Kunststoff-Grundkörpers (5) ausbildet, wobei
- der Montagebereich in einer reflektorartigen Vertiefung (7) des Kunststoff-Grundkörpers (5) angeordnet ist, und
- die zweite Kunststoffkomponente (52) eine Schicht ist, die bis auf die reflektorartige Vertiefung (7) entlang eines Teilbereiches oder entlang der gesamten Vorderseite (6) des Kunststoff-Grundkörpers (5) verläuft,
**dadurch gekennzeichnet, dass**
die Schicht zusätzlich auch entlang zumindest eines Teilbereiches der seitlichen Innenflächen der reflektorartigen Vertiefung (7) verläuft.

2. Gehäuse nach Anspruch 1, **dadurch gekennzeichnet, dass** das Material der zweiten Kunststoffkomponente (52) einen Farbstoff aufweist, der dem optischen Funktionsbereich eine gegenüber dem übrigen Teil des Kunststoff-Grundkörpers (5) verschiedene Farbe verleiht.

3. Gehäuse nach Anspruch 2, **dadurch gekennzeichnet, dass** das Material der zweiten Kunststoffkomponente (52) schwarz eingefärbt ist.

4. Gehäuse nach Anspruch 1, **dadurch gekennzeichnet, dass** das Material der zweiten Kunststoffkomponente (52) mit einem reflexionssteigerenden Material gefüllt ist.

5. Gehäuse nach einem der Ansprüche 1 bis 4, **dadurch gekennzeichnet, dass** der Kunststoff-Grundkörper (5) elektrische Anschlussleiter (31,32) eines Leiterrahmens (3) umschließt und die elektrischen Anschlussleiter (31,32) vom Montagebereich zur Oberfläche des Kunststoff-Grundkörpers (5) verlaufen.

6. Gehäuse nach einem der Ansprüche 1 bis 5, **dadurch gekennzeichnet, dass** der optische Funktionsbereich aus dem gleichen Kunststoff-Grundmaterial gefertigt ist, wie der übrige Teil des Kunststoff-Grundkörpers (5).

7. Gehäuse nach einem der Ansprüche 1 bis 6, **dadurch gekennzeichnet, dass** der optische Funktionsbereich und der übrige Teil des Kunststoff-Grundkörpers (5) Thermoplastmaterial oder Duroplastmaterial aufweisen.

8. Verfahren zum Herstellen eines Gehäuses für ein optoelektronisches Bauelement, bei dem
- mittels eines Zweikomponenten-Spritzverfahrens ein Kunststoff-Grundkörper (5) hergestellt wird,
- in einem ersten Schritt ein tragender Teil des Kunststoff-Grundkörpers (5) aus einer ersten Kunststoff komponente (51) hergestellt wird, und
- in einem weiteren Schritt ein optischer Funktionsbereich des Kunststoff-Grundkörpers (5) aus einer zweiten Kunststoffkomponente (52) hergestellt wird, die sich in mindestens einer optischen Eigenschaft von der ersten Kunststoffkomponente (51) unterscheidet, wobei der Montagebereich in einer reflektorartigen Vertiefung (7) des Kunststoff-Grundkörpers (5) angeordnet ist und die zweite Kunststoffkomponente (52) eine Schicht ist, die bis auf die reflektorartige Vertiefung (7) entlang eines Teilbereiches oder entlang der gesamten Vorderseite (6) des Kunststoff-Grundkörpers (5) verläuft,
**dadurch gekennzeichnet, dass**
die Schicht zusätzlich auch entlang zumindest eines Teilbereiches der seitlichen Innenflächen der reflektorartigen Vertiefung (7) verläuft.

9. Verfahren nach Anspruch 8, bei dem in die zweite Kunststoffkomponente (52) ein Farbstoff eingemischt wird, der diesem eine gegenüber der ersten Kunststoffkomponente (51) verschiedene Farbe verleiht.

10. Verfahren nach Anspruch 9, bei dem die zweite Kunststoffkomponente (52) schwarz eingefärbt ist.

11. Verfahren nach Anspruch 8, bei dem die zweite Kunststoffkomponente (52) mit einem reflexionssteigernden Material gefüllt ist.

12. Verfahren nach einem der Ansprüche 8 bis 11, bei dem elektrische Anschlussleiter (31,32) eines metallischen Leiterrahmens (3) mit der ersten Kunststoffkomponente (51) derart umspritzt werden, dass diese vom Montagebereich für mindestens einen strahlungsemittierenden oder strahlungsdetektierenden Körper (2) zur Oberfläche des Kunststoff-Grundkörpers (5) verlaufen, und nachfolgend in einem weiteren Schritt die zweite Kunststoffkomponente (52) an der ersten Kunststoffkomponente (51) ausgebildet wird.

## Claims

1. Housing for an optoelectronic component (1) with a plastic base body (5), said body having a front side (6) with an assembly region for at least one radiation emitting or radiation detecting body (2), and the plastic base body (5) is formed from at least one first plastic component (51) and at least one second plastic component (52), wherein the second plastic component (52)
- is disposed on the front side (6) of the plastic base body (5),
- is formed of a material that differs from the first plastic component (51) in at least one optical property, and
- forms an optically functional region of the plastic base body (5), wherein
- the assembly region is disposed in a reflector-like cavity (7) of the plastic base body (5), and
- the second plastic component (52) is a layer that extends as far as the reflector-like cavity (7), along a partial region of, or along the entire front side (6) of the plastic base body (5), **characterized in that** in addition, the layer also runs along at least a partial area of the lateral inner surfaces of the reflector-like cavity (7).

2. The housing according to Claim 1, **characterized in that** the material of the second plastic component (52) has a pigment that imparts to the optically functional region different colors relative to the remaining part of the plastic base body (5).

3. The housing according to Claim 2, **characterized in that** the material of the second plastic component (52) is colored black.

4. The housing according to Claim 1, **characterized in that** the material of the second plastic component (52) is filled with a material that increases reflectivity.

5. The housing according to the Claims 1 to 4, **characterized in that** the plastic base body (5) encloses electrical connection leads (31, 32) of a lead frame (3), and the electrical connection leads (31, 32) extend from the assembly region to the surface of the plastic base body (5).

6. The housing according to any one of the Claims 1 to 5, **characterized in that** the optically functional region is produced from the same plastic base material as the remaining part of the plastic base body (5).

7. The housing according to any one of the Claims 1 to 6, **characterized in that** the optically functional region and the remaining part of the plastic base body(5) comprise thermoplast material or duroplast material.

8. Method for producing a housing for an optoelectronic component, in which
- a plastic base body (5) is produced by means of a two-component injection method,
- in a first step, a supporting part of the plastic base body (5) is produced from a first plastic component (51),
- in a further step, an optically functional region of the plastic base body (5) is produced from a second plastic component (52) that differs from the first plastic component (51) in at least one optical property, wherein the assembly region is disposed in a reflector-like cavity (7) of the plastic base body (5), and the second plastic component (52) is a layer that extends as far as the reflector-like cavity (7), along a partial region of, or along the entire front side (6) of the plastic base body (5), **characterized in that** in addition, the layer also runs along at least a partial area of the lateral inner surfaces of the reflector-like cavity (7).

9. The method according to Claim 8, in which a pigment is mixed into the second plastic component (52) that imparts to it a different color relative to the first plastic component (51).

10. The method according to Claim 9, in which the second plastic component (52) is colored black.

11. The method according to Claim 8, in which the second plastic component (52) is filled with a material that increases reflectivity.

12. The method according to any one of the Claims 8 to 11, in which electrical connection leads (31, 32) of a metal lead frame (3) are insert molded to the first plastic component (51) such that said leads extend from the assembly region for at least one radiation emitting or radiation detecting body (2) to the surface of the plastic base body (5), and subsequently in a further step, the second plastic component (52) is formed on the first plastic component (51).

## Revendications

1. Boîtier pour un élément optoélectronique (1) comprenant un corps de base (5) en matière plastique, lequel présente un côté avant (6) doté d'une zone de montage pour au moins un corps (2) émetteur de rayonnement ou détecteur de rayonnement, et le corps de base (5) en matière plastique étant réalisé à partir d'au moins un premier composant (51) en matière plastique et d'au moins un deuxième composant (52) en matière plastique, le deuxième composant (52) en matière plastique
- étant disposé sur le côté avant (6) du corps de base (5) en matière plastique,
- étant formé d'une matière qui se distingue par au moins une caractéristique optique de la matière du premier composant (51) en matière plastique,
et
- formant une zone fonctionnelle optique du corps de base (5) en matière plastique,
- la zone de montage étant disposée dans un approfondissement (7) de type réflecteur du corps de base (5) en matière plastique, et
- le deuxième composant (52) en matière plastique étant une couche qui s'étend jusqu'à l'approfondissement (7) de type réflecteur le long d'une zone partielle ou le long de tout le côté avant (6) du corps de base (5) en matière plastique,
**caractérisé en ce que**
la couche s'étend en plus aussi le long d'au moins une zone partielle des surfaces intérieures latérales de l'approfondissement (7) de type réflecteur.

2. Boîtier selon la revendication 1, **caractérisé en ce que** la matière du deuxième composant (52) en matière plastique présente un colorant qui confère à la zone fonctionnelle une couleur différente par rapport à la partie restante du corps de base (5) en matière plastique.

3. Boîtier selon la revendication 2, **caractérisé en ce que** la matière du deuxième composant (52) en matière plastique est colorée en noir.

4. Boîtier selon la revendication 1, **caractérisé en ce que** la matière du deuxième composant (52) en matière plastique est remplie avec une matière augmentant la réflexion.

5. Boîtier selon l'une quelconque des revendications 1 à 4, **caractérisé en ce que** le corps de base (5) en matière plastique entoure des conducteurs de raccordement (31, 32) électriques d'un cadre conducteur (3), et **en ce que** les conducteurs de raccordement (31, 32) électriques s'étendent de la zone de montage vers la surface du corps de base (5) en matière plastique.

6. Boîtier selon l'une quelconque des revendications 1 à 5, **caractérisé en ce que** la zone fonctionnelle optique est fabriquée dans la même matière plastique de base que la partie restante du corps de base (5) en matière plastique.

7. Boîtier selon l'une quelconque des revendications 1 à 6, **caractérisé en ce que** la zone fonctionnelle optique et la partie restante du corps de base (5) en matière plastique présentent de la matière thermoplastique ou de la matière plastique thermodurcissable.

8. Procédé de fabrication d'un boîtier pour un élément optoélectronique, dans lequel
- un corps de base (5) en matière plastique est fabriqué au moyen d'un procédé d'injection à deux composants,
- dans une première étape, une partie porteuse du corps de base (5) en matière plastique est fabriquée à partir d'un premier composant (51) en matière plastique, et
- dans une étape supplémentaire, une zone fonctionnelle optique du corps de base (5) en matière plastique est fabriquée à partir d'un deuxième composant (52) en matière plastique qui se distingue du premier composant (51) en matière plastique par au moins une caractéristique optique, la zone de montage étant disposée dans un approfondissement (7) de type réflecteur du corps de base (5) en matière plastique, et le deuxième composant (52) en matière plastique étant une couche qui s'étend jusqu'à l'approfondissement (7) de type réflecteur le long d'une zone partielle ou le long de tout le côté avant (6) du corps de base (5) en matière plastique,
**caractérisé en ce que**
la couche s'étend en plus aussi le long d'au moins une zone partielle des surfaces intérieures latérales de l'approfondissement (7) de type réflecteur.

9. Procédé selon la revendication 8, dans lequel un colorant est mélangé dans le deuxième composant (52) en matière plastique, lequel confère à ce dernier une couleur différente par rapport au premier composant (51) en matière plastique.

10. Procédé selon la revendication 9, dans lequel le deuxième composant (52) en matière plastique est coloré en noir.

11. Procédé selon la revendication 8, dans lequel le deuxième composant (52) en matière plastique est rempli avec une matière augmentant la réflexion.

12. Procédé selon l'une quelconque des revendications 8 à 11, dans lequel des conducteurs de raccordement (31, 32) électriques d'un cadre conducteur (3) métallique sont surmoulés avec le premier composant (51) en matière plastique de sorte que ceux-ci s'étendent de la zone de montage vers la surface du corps de base (5) en matière plastique pour au moins un corps (2) émetteur de rayonnement ou détecteur de rayonnement, et dans lequel ensuite, dans une étape supplémentaire, le deuxième composant (52) en matière plastique est formé sur le premier composant (51) en matière plastique.
